# EUROPEAN PATENT SPECIFICATION

(11) **EP 3 806 603 B1**
(45) Date of publication and mention of the grant of the patent: **15.03.2023**
(21) Application number: 18920804.4
(22) Date of filing: 31.05.2018
(51) Int. Cl.: H05K 13/04

(54) **WASTE TAPE CONVEYING DEVICE AND COMPONENT MOUNTING SYSTEM**
ABFALLBANDFÖRDERVORRICHTUNG UND KOMPONENTENMONTAGESYSTEM
DISPOSITIF DE TRANSPORT DE BANDE PERDUE ET SYSTÈME DE MONTAGE DE COMPOSANTS

(43) Date of publication of application: 14.04.2021
(73) Proprietor: Fuji Corporation, Chiryu-shi, Aichi 472-8686 (JP)
(72) Inventor: IISAKA, Jun, Chiryu-shi, Aichi 472-8686 (JP); TSUGE, Kuniaki, Chiryu-shi, Aichi 472-8686 (JP)
(74) Representative: Grünecker Patent- und Rechtsanwälte PartG mbB
(86) International application number: PCT/JP2018/020943
(87) International publication number: WO 2019/229927

(56) References cited:
- WO-A1-2007/055112
- WO-A1-2015/045018
- JP-A- H11 284 395
- JP-A- 2002 046 849
- JP-A- 2002 171 090
- JP-A- 2006 248 682
- JP-A- 2007 095 761
- JP-A- 2017 069 439
- JP-B2- 6 267 216

## Description

### Technical Field

The present specification discloses a waste tape conveyance device and a component mounting system.

### Background Art

Conventionally, a component mounting system in which multiple component mounters are installed along a board conveyance direction is known. For example, Patent Literature 1 discloses a component mounting system including a waste tape conveyance device for conveying a waste tape generated with a supply of components by the component supply device (tape feeder) in a direction parallel to the board conveyance direction. Waste tape conveyance device includes multiple conveyor devices installed independently for each component mounter. Multiple conveyor devices subsequently deliver the waste tape generated by each component mounter to the conveyor device adjacent on the downstream side in the conveyance direction of the waste tape, so that eventually the multiple conveyor devices discharge the waste tape to the collection box installed on an end side of the component mounter in the board conveyance direction. Patent Literature 2 discloses that a controller judges that a storage box for waste tape of a single component mounter is full by counting the number of printed circuit boards produced and calculating the total amount of waste tape produced for the components used thereon.

### Patent Literature

Patent Literature 1: WO 2015/045018 & JP 6 267216 B2
Patent Literature 2: JP H11 284395 A

### Summary of the Invention

### Technical Problem

In Patent Literature 1 above, although it is described that the waste tape generated by each component mounter is sequentially conveyed while being delivered to the conveyor device to which the conveyor device provided in each component mounter is adjacent, it has not been mentioned about how to operate multiple conveyor devices. In the component mounting system described in Patent Literature 1, it is conceivable to keep operating multiple conveyor devices, however in a case where the collection box is full or when an operation of a portion of the conveyor device is stopped due to breakdown or the like, there is a possibility that the waste tape overflows from the collection box or the conveyor device.

A main object of the present disclosure is to suppress the overflow from the waste tape collection section or the conveyor device while the waste tape generated by each component mounter is collected by the waste tape collection section, in the device having multiple conveyor devices provided independently for each component mounter.

### Solution to Problem

The present disclosure has taken the following means to achieve the main object described above.

The invention is set out in the appended set of claims. Further embodiments are defined in the dependent claims.

### Brief Description of Drawings

Fig. 1 is a configuration diagram showing a schematic configuration of component mounting system 10 according to the present embodiment.
Fig. 2 is a configuration diagram showing a schematic configuration of component mounter 20.
Fig. 3 is a configuration diagram showing a schematic configuration of waste tape discharge device 30.
Fig. 4 is a configuration diagram schematically showing a configuration of waste tape conveyance device 40.
Fig. 5 is an explanatory view showing a state of delivery of waste tape between adjacent conveyor devices 41.
Fig. 6 is a configuration diagram showing a schematic configuration of waste tape collection unit 50.
Fig. 7 is an explanatory view showing an electrical connection relationship between each control device 48 of multiple modules M and control device 58 of waste tape collection unit 50.
Fig. 8 is a flowchart showing an example of a non-most downstream conveyor conveyance control routine.
Fig. 9 is a flowchart showing an example of the most downstream conveyor conveyance control routine.
Fig. 10 is an explanatory view showing a state of the operation of conveyor device 41 of the present embodiment.
Fig. 11 is a flowchart showing an example of a mounting operation stop control routine.
Fig. 12 is an explanatory view showing a state of the operation of conveyor device 41 of a modified example.
Fig. 13 is a flowchart showing a mounting operation stop control routine of a modified example.

### Description of Embodiments

Next, embodiments of the present disclosure will be described with reference to the drawings.

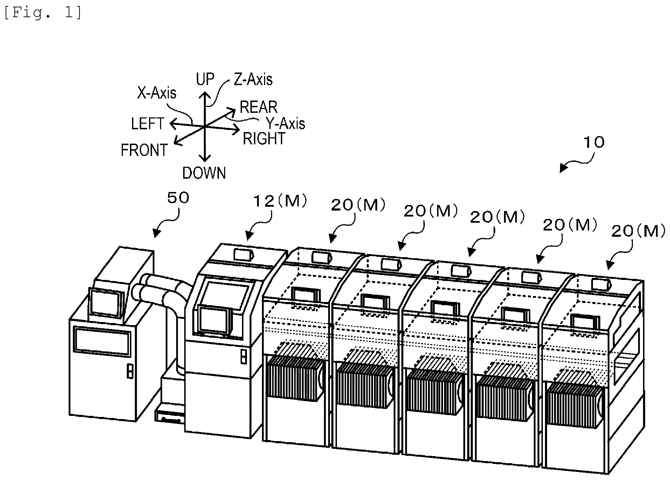

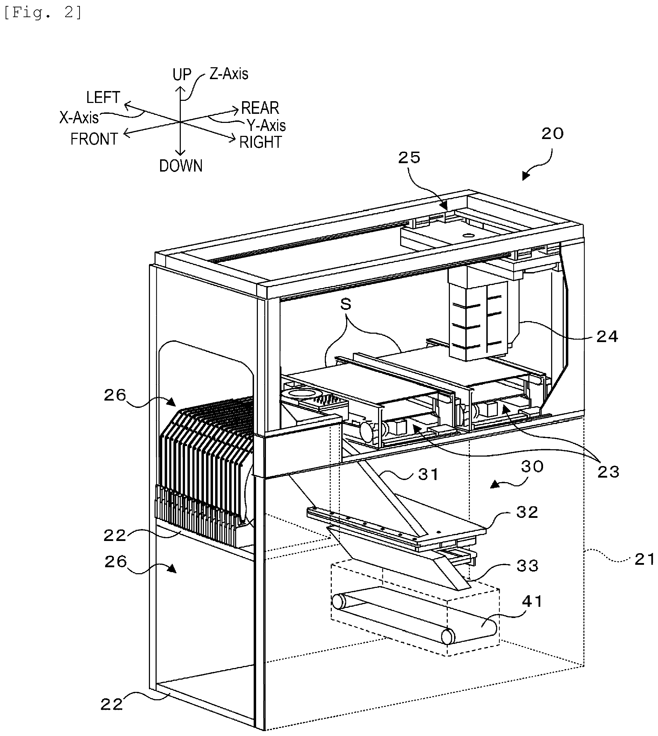

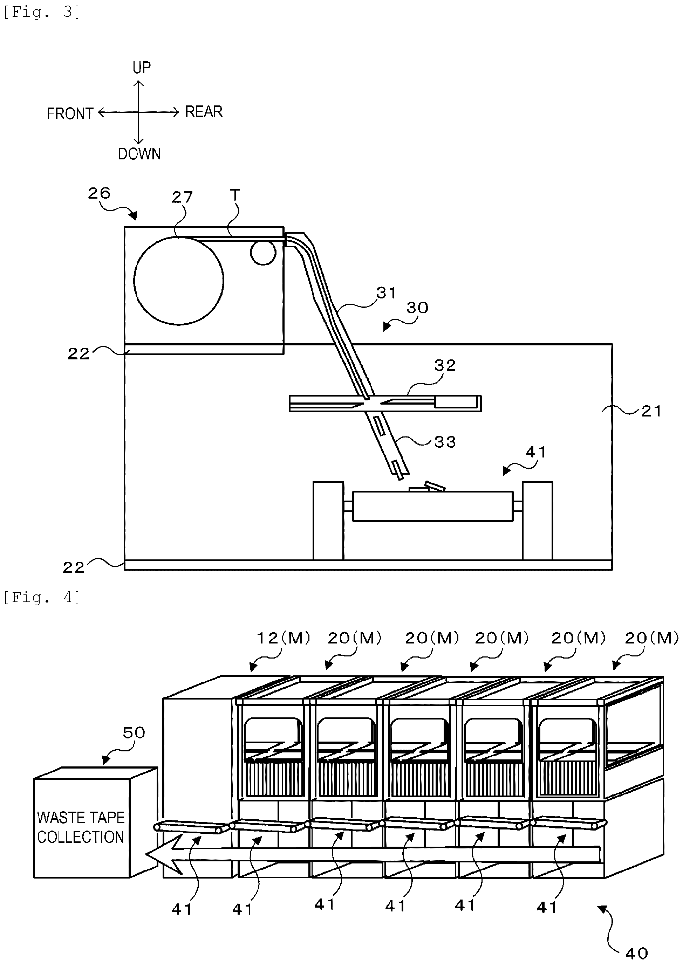

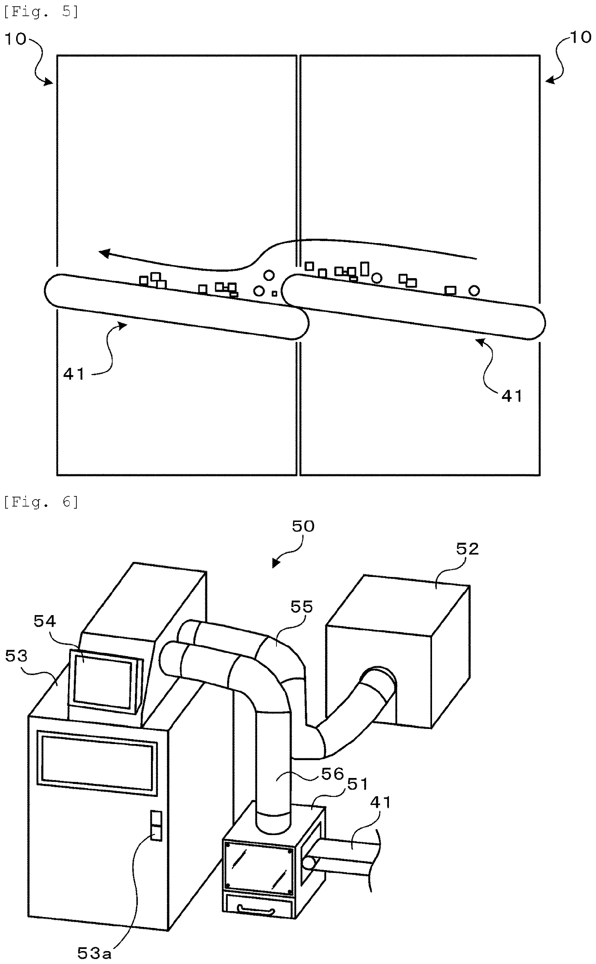

Fig. 1 is a configuration diagram showing a schematic configuration of component mounting system 10 according to the present embodiment. Fig. 2 is a configuration diagram showing a schematic configuration of component mounter 20. Fig. 3 is a configuration diagram showing a schematic configuration of waste tape discharge device 30. Fig. 4 is a configuration diagram schematically showing a configuration of waste tape conveyance device 40. Fig. 5 is an explanatory view showing a state of delivery of waste tape between adjacent conveyor devices 41.

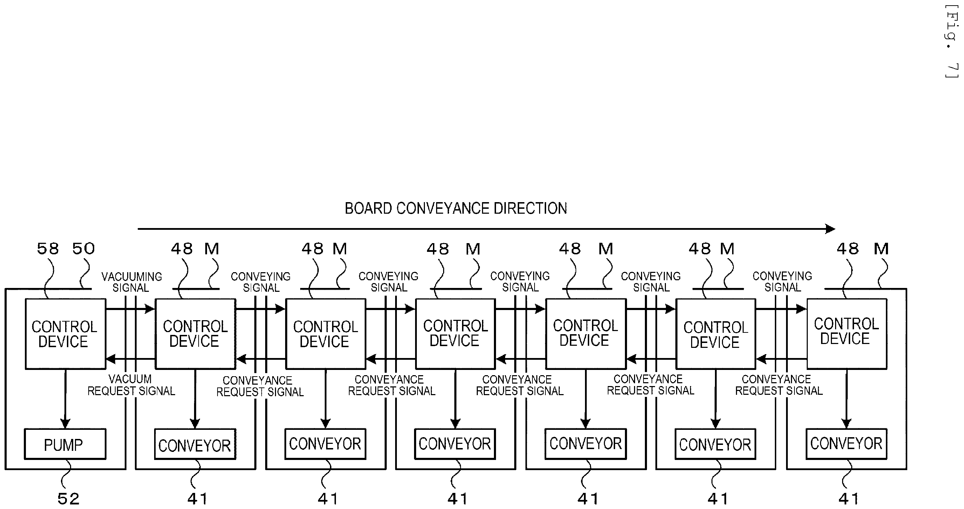

Fig. 6 is a configuration diagram showing a schematic configuration of waste tape collection unit 50. Fig. 7 is an explanatory view showing an electrical connection relationship between each control device 48 of multiple modules M and control device 58 of waste tape collection unit 50. In Figs. 1 and 2, a left-right direction is set as an X-axis direction, a front-rear direction is set as a Y-axis direction, and a up-down direction is set as a Z-axis direction.

Component mounting system 10 includes printing machine 12, multiple component mounters 20, waste tape conveyance device 40 (see Fig. 4), and waste tape collection unit 50, as shown in Fig. 1. Printing machine 12 is a solder printing machine for printing solder on board S. Component mounters 20 are aligned along the board conveyance direction (X direction) to mount the component on board S. Printing machine 12 and component mounters 20 are installed side by side in board conveyance direction in this order to constitute a component mounting line. In the present embodiment, each device constituting the component mounting line is also referred to as module M.

Component mounter 20, as shown in Fig. 2, includes housing 21, feeder base 22, board conveyance device 23, head 24, and head moving mechanism 25. Multiple feeder bases 22 are aligned in the X direction and detachably hold feeder 26. Board conveyance device 23 is a belt conveyor device and conveys board S from left to right. Head 24 holds a suction nozzle, picks up component P supplied from feeder 26 mounted on feeder base 22 by suction nozzle, and mounts the component on board S. Head moving mechanism 25 moves head 24 in the front-rear direction and the left-right direction (XY-directions).

Feeder 26, as shown in Fig. 3, includes reel 27 on which tape T is wound. Tape T has a recess arranged at predetermined intervals in the longitudinal direction and component P is accommodated in the recess. Component P is protected by a cover film attached to a upper surface of tape T. Feeder 26 supplies component P to a suction position in an exposed state, by pulling out tape T from the reel 27 by a feeding device (not shown) and peeling the cover film from tape T. The used tape from which component P has been picked up by the suction nozzle (hereinafter, referred to as a waste tape) is discharged by waste tape discharge device 30.

Waste tape discharge device 30, as shown in Fig. 3, includes introduction duct 31 for introducing the waste tape fed from feeder 26 provided behind feeder 26 mounted on feeder base 22, tape cutting device 32 for finely cutting the introduced waste tape by the cutter, and discharge duct 33 for discharging the cut waste tape. Each time feeder 26 feeds tape T for the supply of component P, tape cutting device 32 cuts the waste tape by driving the cutter. Waste tape cut by tape cutting device 32 is supplied to conveyor device (belt conveyor device) 41 through discharge duct 33 and is conveyed to the outside of component mounter 20 by conveyor device 41.

Waste tape conveyance device 40, as shown in Fig. 4, includes conveyor devices 41. Conveyor devices 41 are provided independently for each module M. In a state in which multiple modules M constituting the component mounting line are installed side by side in the board conveyance direction, each conveyor device 41 is brought into a state of being aligned into a line in the board conveyance direction. Each conveyor device 41, as shown in Fig. 5, is installed to be inclined upward toward the waste tape conveyance direction and is configured such that end portions of adjacent conveyor devices 41 overlap vertically to each other. Thus, each conveyor device 41 is possible to smoothly deliver the waste tape to adjacent conveyor device 41 and to prevent the waste tape from falling during the delivery. In the present embodiment, the waste tape conveyance direction is defined in a direction opposite to the board conveyance direction (an upstream direction of the component mounting line).

Waste tape collection unit 50, as shown in Fig. 1, is installed to be adjacent to module M (printing machine 12) at a starting end in the board conveyance direction, and collects the conveyed waste tape by waste tape conveyance device 40. Waste tape collection unit 50, as shown in Fig. 6, includes vacuum section 51 for receiving the waste tape from most downstream conveyor device 41 in the waste tape conveyance direction, vacuum pump 52 for generating a vacuum force that causes vacuum section 51 to vacuum the waste tape, and accommodation section 53 for accommodating the waste tape vacuumed from vacuum section 51. Accommodation section 53 is a box-shaped housing and knob 53a is provided on the front door. An operator can collect the waste tape accommodated in accommodation section 53 and clean the inside of accommodation section 53 by holding knob 53a and opening the front door of accommodation section 53. Waste tape collection unit 50 also includes display operation section 54 for displaying the accommodating status of the waste tape to accommodation section 53 or stopping an operation of vacuum pump 52 by an operation of the operator.

Multiple conveyor devices 41, as shown in Fig. 7, are controlled by control devices 48 provided in each corresponding module M. In the present embodiment, control device 48, in addition to conveyor device 41, controls the entire module. For example, control device 48 for controlling component mounter 20 as module M, in addition to conveyor device 41, controls board conveyance device 23, head 24, or head moving mechanism 25. Vacuum pump 52 is also controlled by control device 58 provided in waste tape collection unit 50.

Further, as shown in Fig. 7, control device 48 of most downstream conveyor device 41 in the waste tape conveyance direction among multiple conveyor devices 41 and control device 58 of waste tape collection unit 50 are connected to each other via an input and output interface. Control device 48 of most downstream conveyor device 41 in the waste tape conveyance direction outputs a vacuum request signal requesting for vacuuming the waste tape (activation of vacuum pump 52) to control device 58 of waste tape collection unit 50 via an output interface. Further, control device 48 of most downstream conveyor device 41 in the waste tape conveyance direction inputs a vacuuming signal indicating that the waste tape is being vacuumed from control device 58 of waste tape collection unit 50 via the input interface. On the other hand, control device 58 of waste tape collection unit 50 inputs a vacuum request signal from control device 48 of most downstream conveyor device 41 in the waste tape conveyance direction via an input interface, and outputs a vacuuming signal to the control device 48 via an output interface. In the present embodiment, the vacuum request signal is output by any of an on (high level) signal and an off (low level) signal. That is, the vacuum request signal is a turn-on state when vacuuming the waste tape is requested, while it is a turn-off state when vacuuming the waste tape is not requested. The output of the vacuuming signal is also similarly performed by any of the on (high level) signal and the off (low level) signal. That is, the vacuuming signal is a turn-on state when vacuum pump 52 is operating (vacuuming the waste tape), while it is a turn-off state when vacuum pump 52 is stopping (stopping vacuuming the waste tape). In addition, the vacuuming signal becomes also turn-off state (low level) when the power supply of waste tape collection unit 50 is turned off, when the operator's instruction is to stop vacuuming the waste tape, or when vacuuming the waste tape is stopped due to some abnormality.

Further, as shown in Fig. 7, control devices 48 of conveyor devices 41 adjacent to each other among multiple conveyor devices 41 are also connected to each other via the input and output interface. Control device 48 of upstream conveyor device 41 in the waste tape conveyance direction among multiple conveyor devices 41 adjacent to each other outputs a conveyance request signal requesting the conveyance of the waste tape to control device 48 of downstream conveyor device 41 in the waste tape conveyance direction via the output interface. Further, control device 48 of upstream conveyor device 41 in the waste tape conveyance direction inputs a conveying signal indicating that the waste tape is being conveyed from control device 48 of downstream conveyor device 41 in the waste tape conveyance direction via the input interface. On the other hand, control device 48 of downstream conveyor device 41 in the waste tape conveyance direction inputs the conveyance request signal from control device 48 of upstream conveyor device 41 in the waste tape conveyance direction via the input interface, and outputs the conveying signal to control device 48 of upstream conveyor device 41 in the waste tape conveyance direction via the output interface. In the present embodiment, the output of the conveyance request signal is performed by either the on (high level) signal and off (low level) signal. That is, the conveyance request signal is a turn-on state when the conveyance of the waste tape is requested, while it is a turn-off state when the conveyance of the waste tape is not requested. The output of the conveying signal is also similarly performed by either the on (high level) signal and off (low level) signal. That is, the conveying signal is a turn-on state when conveyor device 41 is operating (conveying the waste tape), while it is a turn-off state when conveyor device 41 is stopping (stopping the conveyance of the waste tape). In addition, conveying signal is turned off (low level) even when the power supply of module M provided with corresponding conveyor device 41 is turned off or when the conveyance of the waste tape is stopped due to some abnormality.

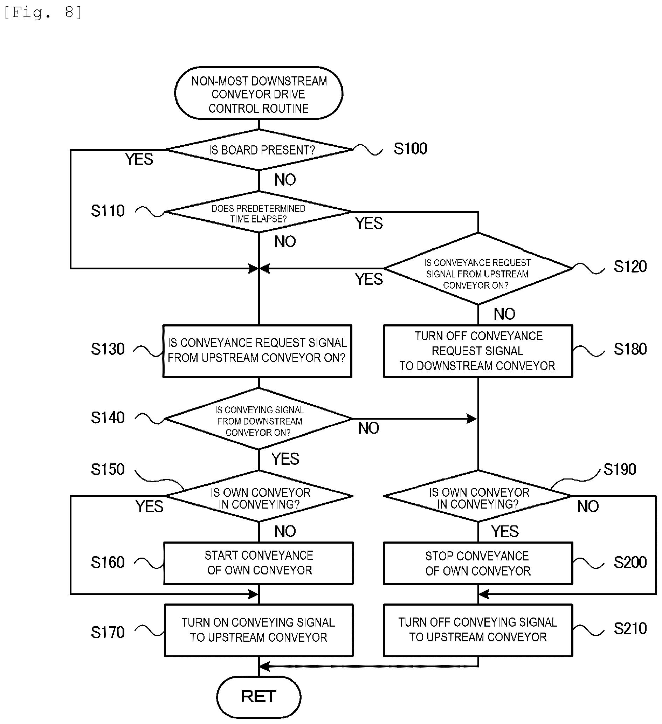

Hereinafter, an operation of waste tape conveyance device 40 configured as described hereto will be described. Fig. 8 is a flowchart showing an example of a non-most downstream conveyor drive control routine. The routine is repeatedly executed every predetermined time (for example, every few msec or several tens of msec) by respective control devices 48 of conveyor devices 41 other than most downstream conveyor device 41 in the waste tape conveyance direction (the non-most downstream side in the waste tape conveyance direction) among multiple conveyor devices 41.

When the non-most downstream conveyor drive control routine is executed, control device 48 first determines whether board S comes to component mounter 20 including control target conveyor device 41 (step S100), when it is determined that board S does not come, control device 48 determines whether the state continues for a predetermined time (for example, several seconds or tens of seconds) or more (step S110). These determinations are to determine whether the waste tape is discharged to own conveyor (whether the waste tape generation condition is established). That is, when board S comes, component mounter 20 picks up component P from tape T supplied from feeder 26 and mount component P on board S. Waste tape from which component P is picked up is cut by tape cutting device 32 and discharged to the own conveyor. Therefore, control device 48 is possible to determine whether the waste tape is discharged to the own conveyor by determining whether board S comes to component mounter 20. Control device 48, when it is determined that board S does not come and the state continues for the predetermined time or more, that is, when the waste tape generation condition is not established, determines whether the conveyance request signal input from conveyor device 41 adjacent on an upstream side in the waste tape conveyance direction (also referred to as an upstream conveyor) is in the on (high level) state (step S120).

When it is determined that board S comes, that board S does not come but the state is not continued for a predetermined time or more, or that the conveyance request signal input from the upstream conveyor is turned on, control device 48 determines that the waste tape generation condition is established or that the conveyance of the waste tape from the upstream conveyor is requested and turns on (high level) the conveyance request signal to be output to conveyor device 41 adjacent on a downstream side in the waste tape conveyance direction (also referred to as a downstream conveyor)(step S130). Then, control device 48 determines whether the conveying signal input from the downstream conveyor is in on state (step S140). Control device 48, when it is determined that the conveying signal input from the downstream conveyor is on, determines whether the own conveyor is in the conveying (in operation) (step S150). Control device 48, when it is determined that the own conveyor is not conveying the waste tape, starts the conveyance of the own conveyor (step S160), turns on the conveying signal to be output to the upstream conveyor (step S170), and ends the routine. On the other hand, when it is determined that the own conveyor is in the conveyance, control device 48 skips step S160, turns on the conveying signal to be output to the upstream conveyor (step S170), and ends the routine. As described above, when the waste tape generation condition is established or the conveyance request signal input from the upstream conveyor is turned on, the own conveyor turns on the conveyance request signal to be output to the downstream conveyor, and when the conveying signal input from the downstream conveyor is turned on, the own conveyor starts to convey the waste tape and turns on the conveying signal to be output to the upstream conveyor.

When it is determined that the state in which the board S does not come continues for a predetermined time or more and that the conveyance request signal input from the upstream conveyor is in off state in steps S100 to S120, control device 48 turns off the conveyance request signal to be output to the downstream conveyor (step S180). Then, control device 48 determines whether the own conveyor is in the conveyance (in operation) (step S190). When it is determined that the own conveyor is in the conveyance, control device 48 stops the conveyance of the own conveyor (step S200), turns off the conveying signal to be output to the upstream conveyor (step S210), and end the routine. On the other hand, when it is determined that the own conveyor is not in the conveyance, control device 48 skips step S200, turns off the conveying signal to be output to the upstream conveyor (step S210) and ends the routine. That is, when the waste tape generation condition is not established and the conveyance request signal input from the upstream conveyor is in off state, the own conveyor turns off the conveyance request signal to be output to the downstream conveyor, stops conveying the waste tape, and turns off the conveying signal to be output to the upstream conveyor.

When it is determined that the conveying signal from the downstream conveyor is in off state in step S140, control device 48 determines whether the own conveyor is in the conveyance (in operation) (step S190). Then, when it is determined that the own conveyor is in the conveyance, control device 48 stops the conveyance of the own conveyor (step S200), turns off the conveying signal to be output to the upstream conveyor (step S210), and ends the routine. On the other hand, when it is determined that the own conveyor is not in the conveyance, control device 48 skips step S200, turns off the conveying signal to be output to the upstream conveyor (step S210) and ends the routine. That is, even when the conveyance request signal to be output to the downstream conveyor is turned on, the own conveyor does not convey the waste tape unless the conveying signal input from the downstream conveyor is on. Thus, since the own conveyor does not convey the waste tape in a state where the downstream conveyor is stopped, it is possible to prevent the waste tape from being placed in one place and overflowing from the own conveyor. As described above, the conveying signal is turned off even when the power supply of the downstream conveyor (module M) is turned off or some abnormality occurs. Therefore, the own conveyor can appropriately respond to the occurrence of power-off or abnormality of the downstream conveyor.

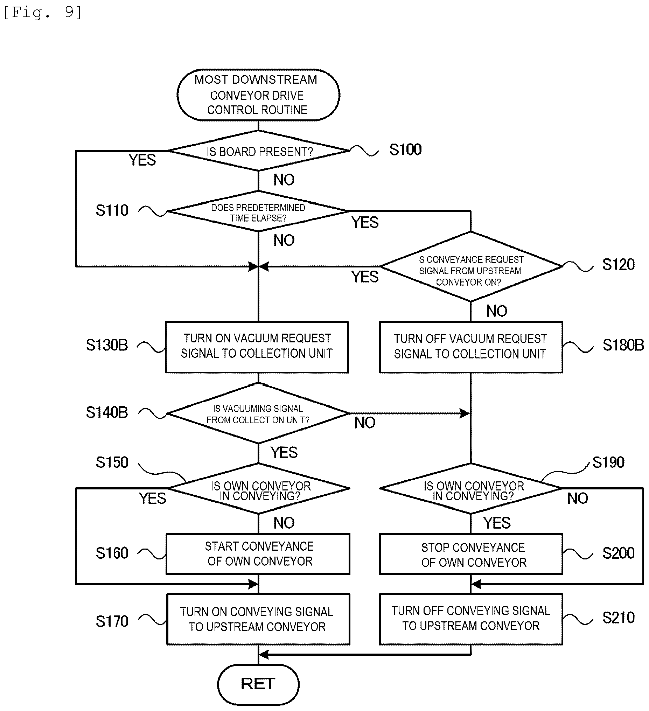

Fig. 9 is a flowchart showing an example of the most downstream conveyor drive control routine. The routine is repeatedly executed every predetermined time (for example, every few msec or several tens of msec) by the control device 48 of the most downstream conveyor device 41 in the waste tape conveyance direction among multiple conveyor devices 41. In the processes in Fig. 9, the same processes as those in Fig. 8 are denoted by the same step numbers, and a detailed description thereof is omitted.

In the most downstream conveyor drive control routine, when it is determined that board S comes, that board S does not come and the state does not continue for a predetermined time or more, or that the conveyance request signal input from the upstream conveyor is in on state in steps S100 to S120, control device 48 turns on (high level) the vacuum request signal to be output to control device 58 of waste tape collection unit 50 (step S130B). Control device 58, which inputs the vacuum request signal in on state, starts vacuuming the waste tape by driving the vacuum pump 52, and turns on the vacuuming signal to be output to conveyor device 41 adjacent to waste tape collection unit 50. Then, control device 48 determines whether the vacuuming signal input from the control device 58 of waste tape collection unit 50 is in on state (step S140B). when it is determined that the vacuuming signal input from control device 58 of waste tape collection unit 50 is in on state, if the own conveyor is not in the conveyance (in the operation) (step S150), control device 48 starts the conveyance of the own conveyor (step S160), turns on the conveyance signal to be output to the upstream conveyor (step S170), and ends the routine. Thus, the most downstream own conveyor in the waste tape conveyance direction turns on the vacuum request signal to be output the control device 58 of waste tape collection unit 50, waits for the vacuuming signal input from the control device 58 to be turned on, and starts to convey the waste tape and turns on the conveying signal to be output to the upstream conveyor.

When it is determined that the state in which board S does not come continues for a predetermined time or more and that the conveyance request signal input from the upstream conveyor is in off state in steps S100 to S120, control device 48 turns off the vacuum request signal to be output to control device 58 of waste tape collection unit 50(step S180B). Control device 58 that inputs the vacuum request signal in off state stops the driving of vacuum pump 52 and ends vacuuming the waste tape. Thus, it is possible to suppress unnecessary driving of vacuum pump 52 and a suppression of unnecessary energy consumption and a reduction of noise can be achieved. Then, when the own conveyor is in the conveyance (step S190) control device 48 stops the conveyance of the own conveyor (step S200), turns on the conveying signal to be output to the upstream conveyor (step S210), and the routine is ended. That is, when the waste tape generation condition is not established and the conveyance request signal input from the upstream conveyor is in off state, the most downstream own conveyor in the waste tape conveyance direction turns off the vacuum request signal to be output to waste tape collection unit 50, stops the conveyance of the waste tape, and turns off the conveying signal output to the upstream conveyor.

When it is determined that the vacuuming signal input from control device 58 of waste tape collection unit 50 in step S140B is in off state, if the own conveyor is in the conveyance (step S190), control device 48 stops the conveyance of the own conveyor (step S200), turns off the conveying signal to be output to the upstream conveyor (step S210), and the routine is ended. That is, even when the vacuum request signal to be output to waste tape collection unit 50 is turned on, the own conveyor does not convey the waste tape unless the vacuuming signal input from waste tape collection unit 50 is in on state. Thus, since the own conveyor does not convey the waste tape in a state where waste tape collection unit 50 (vacuum pump 52) is stopped, it is possible to prevent the waste tape from being placed in one place and overflowing from the own conveyor. As described above, the vacuuming signal is turned off even when the power supply of waste tape collection unit 50 is turned off, when the operator's instruction is to stop vacuuming the waste tape, or when the vacuum of the waste tape is stopped due to some abnormality. Therefore, the own conveyor can appropriately respond to the occurrence of power-off of waste tape collection unit 50, a vacuum stop manually made, or occurrence of an abnormality.

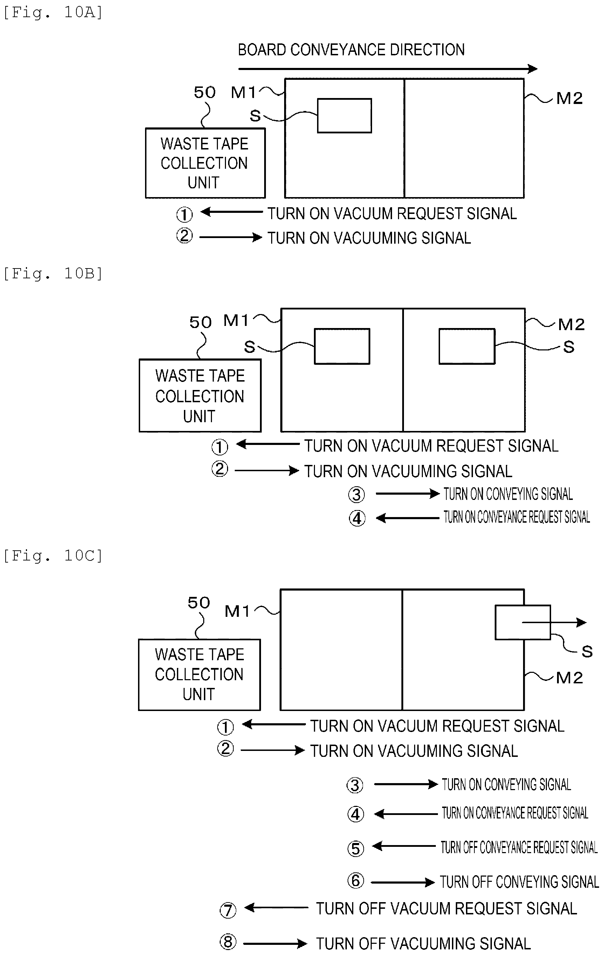

Fig. 10 is an explanatory view showing an aspect of the operation of conveyor device 41 of the present embodiment. For convenience of explanation, the component mounting line in the drawing is configured by arranging first module M1 and second module M2 in order from the upstream side in the board conveyance direction (downstream side in the waste tape conveyance direction). When new board S comes, the waste tape generation condition of first module M1 is established and first module M1 turns on the vacuum request signal to be output to waste tape collection unit 50. When the vacuum request signal in on state is input from first module M1, waste tape collection unit 50 starts the vacuum of the waste tape and turns on the vacuuming signal to be output to first module M1. When the vacuuming signal in on state is input from the waste tape collection unit 50, first module M1 starts the conveyance of the waste tape and turns on the conveying signal to be output to second module M2 upstream in the waste tape conveyance direction. When board S unloaded from the first module M1 comes, the waste tape generation condition of second module M2 is established and second module M2 turns on the conveyance request signal to be output to first module M1 downstream in the waste tape conveyance direction. Since the conveying signal in on state is input from first module M1, second module M2 starts the conveyance of the waste tape. In this manner, waste tape conveyance device 40 subsequently conveys the waste tape generated by the mounting operation of each of the modules M1 and M2 (component mounter 20) to waste tape collection unit 50. Then, when the predetermined time elapses after final board S is unloaded from the first module M1, the establishment of the waste tape generation condition of first module M1 is released. However, since board S comes to second module M2 upstream in the waste tape conveyance direction, and the conveyance request signal in on state is input to first module M1 from second module M2, first module M1 continues the conveyance of the waste tape. When the predetermined time elapses after the final board S is unloaded from the second module M2, the establishment of the waste tape generation condition of the second module M2 is released. Second module M2 stops the conveyance of the waste tape and turns off the conveyance request signal to be output to first module M1. When the conveyance request signal in off state is input from the second module M2, first module M1 stops the conveyance of the waste tape, turns off the conveying signal output to second module M2, and turns off the vacuum request signal to be output to waste tape collection unit 50. When the vacuum request signal in off state is input from first module M1, waste tape collection unit 50 stops vacuuming the waste tape and turns off the vacuuming signal to be output to first module M1.

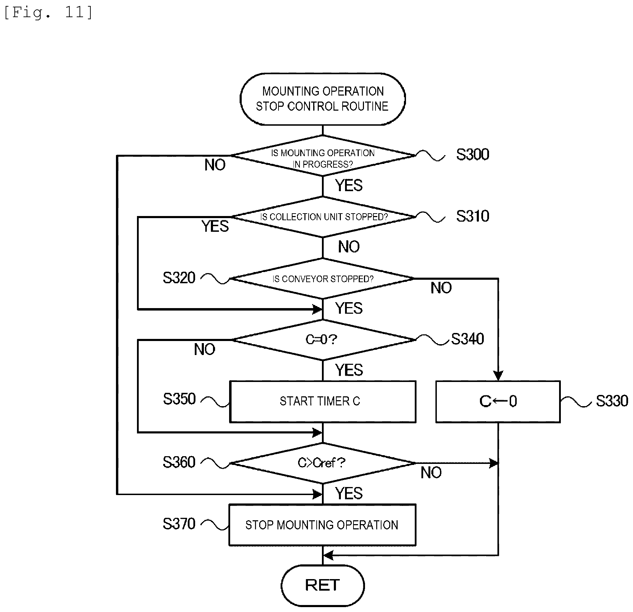

The following description is a description of the operation of component mounter 20 when waste tape collection unit 50 and conveyor device 41 are stopped during the mounting operation. Fig. 11 is a flowchart showing an example of a mounting operation stop control routine executed by control device 48 of each component mounter 20. This routine is executed repeatedly every predetermined time (for example, every few msec or tens of msec).

When the mounting operation stop control routine is executed, the control device 48 first determines whether the mounting operation including the pickup operation is in progress (step S300). When control device 48 determines that the mounting operation is not in progress, the routine is ended. On the other hand, when it is determined that the mounting operation is in progress, control device 48 determines whether waste tape collection unit 50 is stopped (step S310) and whether waste tape conveyance device 40 (conveyor device 41) is stopped (step S320), respectively. When it is determined that waste tape collection unit 50 is not stopped and waste tape conveyance device 40 is not stopped, control device 48 resets timer C to a value of 0 (step S330) and the routine is ended. On the other hand, when it is determined that waste tape collecting unit 50 is stopped, or that waste tape conveyance device 40 (the conveyor device 41) is stopped, control device 48 determines whether timer C is the value of 0 (step S340). When it is determined that timer C is the value of 0, control device 48 starts measurement of timer C (step S350), and when it is determined that timer C is not the value of 0, since the measurement of the timer C has already started, control device 48 skips step S350. Control device 48 determines whether timer C is larger than threshold Cref(step S360). Here, an amount of the waste tapes generated by the pickup operation is estimated by using timer C. Threshold Cref is an allowable amount to prevent the waste tape from overflowing from the own conveyor even when the waste tape is discharged to the own conveyor that is stopped, and is predetermined by a size of the own conveyor and the like. When it is determined that timer C is less than or equal to threshold Cref, control device 48 the routine is ended while continuing the mounting operation, and when it is determined that timer C is greater than the threshold Cref, control device 48 stops the mounting operation (step S370), and the routine is ended. As described above, when waste tape collecting unit 50 or waste tape conveyance device 40 (conveyor device 41) is stopped during the mounting operation, component mounter 20 continues the mounting operation until timer C reaches threshold Cref (until a predetermined time elapses) and stops the mounting operation when timer C reaches threshold Cref. Thus, component mounting system 10 is possible to more reliably prevent the waste tape from overflowing from conveyor device 41 in the middle of being conveyed to waste tape collection unit 50. Further, in component mounting system 10, production efficiency can be increased in comparison with a system in which the component mounting operation is immediately stopped when waste tape collection unit 50 is stopped during the component mounting operation, or when any of conveyor devices 41 are stopped.

Here, the correspondence relationship between the main elements of the embodiment and the main elements described in the scope of the claims will be described. That is, feeder 26 corresponds to a feeder, board conveyance device 23 corresponds to a board conveyance device, tape cutting device 32 corresponds to a cutting device, component mounter 20 corresponds to a component mounter, component mounting system 10 corresponds to a component mounting system, conveyor device 41 corresponds to a conveyor device, and waste tape collection section 50 corresponds to a waste tape collection unit.

Waste tape conveyance device 40 of the above-described embodiment conveys the waste tape discharged from each component mounter 20 constituting the component mounting line to waste tape collection unit 50 provided at the conveyance end thereof. Waste tape conveyance device 40 has conveyor devices 41 provided independently for each component mounter 20. When the waste tape generation condition is established or the conveyance request signal input from the upstream conveyor is turned on, conveyor device 41 adjacent on the downstream conveyor among multiple conveyor devices turns on the conveyance request signal to be output to the downstream conveyor, and when the conveying signal input from the downstream conveyor is turned on, the conveyance device 41 starts conveying. Further, when the waste tape generation condition is not established and the conveyance request signal input from the upstream conveyor is in off state, conveyor device 41 adjacent on the downstream conveyor stops conveying and turns off the conveyance request signal to be output to the downstream conveyor. On the other hand, when the waste tape generation condition is established or the conveyance request signal input from the upstream conveyor is turned on, the conveyor device 41 to which waste tape collection unit 50 is adjacent among multiple conveyor devices 41 turns on the vacuum request signal to be output to waste tape collection unit 50, and when the vacuuming signal input from waste tape collection unit 50 is turned on, the conveyance device 41 starts conveying. Further, when the waste tape generation condition is not established and the conveyance request signal input from the upstream conveyor is OFF, conveyor device 41 to which waste tape collection unit 50 is adjacent stops conveying and turns off the vacuum request signal to be output to waste tape collection unit 50. Thus, waste tape conveyance device 40 can prevent the conveyor device 41 from operating when, for example, waste tape collection unit 50 is in a state in which the waste tape is uncollectable or when the conveyor device 41 on the downstream side in the waste tape conveyance direction is stopped. As a result, waste tape conveyance device 40 can prevent the waste tape from overflowing from conveyor device 41 in the middle of being conveyed to waste tape collection unit 50. Further, in waste tape conveyance device 40, energy saving can be achieved in comparison with a device in which multiple conveyor devices 41 are always operating.

Further, when the vacuuming signal is turned off due to the waste tape collection unit 50 being stopped during conveyance, conveyor device 41, adjacently provided to waste tape collection unit 50, stops the conveyance and turns off the conveying signal which has been output to the upstream conveyor. Thus, the conveyor device 41 can appropriately respond, even when waste tape collection unit 50 in the middle of the conveyance is stopped.

Further, conveyor device 41 to which the downstream conveyor is adjacent stops conveying and turns off the conveying signal to be output to the upstream conveyor when the downstream conveyor stops conveying during the conveyance and the conveying signal is turned off. Thus, the conveyor device 41 can appropriately respond, even when the downstream conveyor is stopped in the middle of conveyance.

It is to be understood that the present disclosure is not limited to the above-described embodiments, and may be implemented in various aspects as long as it it is limited to the technical scope of the appended claims.

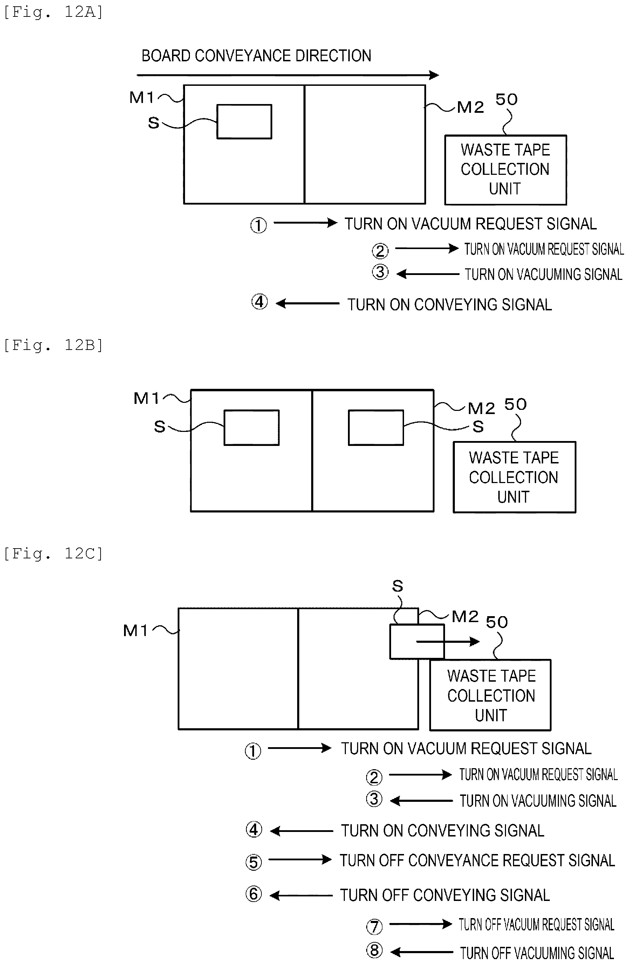

For example, in the above-described embodiment, waste tape conveyance device 40 conveys the waste tape in a direction opposite to the board conveyance direction. Waste tape conveyance device 40 may be configured to convey the waste tape in the same direction as the board conveyance direction. In this case, the waste tape collection unit 50 is installed adjacent to module M at the end in the board conveyance direction. Fig. 12 is an explanatory view showing a state of the operation of conveyor device 41 of a modified example. For convenience of explanation, the component mounting line in the drawing is configured such that first module M1 and the second module M2 are arranged in this order from the upstream side in the board conveyance direction (upstream side in the waste tape conveyance direction). When new board S comes, the waste tape generation condition of first module M1 is established and first module M1 turns on the conveyance request signal to be output to the second module M2. Second module M2 turns on the vacuum request signal to be output to waste tape collection unit 50 when the conveyance request signal in on state is input from first module M1. When the vacuum request signal in on state is input from second module M2, waste tape collection unit 50 starts vacuuming the waste tape and turns on the vacuuming signal to be output to second module M2. When the vacuuming signal in on state is input from waste tape collection unit 50, second module M2 starts the conveyance of the waste tape and turns on the conveying signal to be output to the first module M1. First module M1 starts the conveyance of the waste tape when the conveying signal in on state is input from second module M2. In this manner, waste tape conveyance device 40 subsequently conveys the waste tape generated by the mounting operation of each module M (component mounter 20) to waste tape collection unit 50. Then, when the predetermined time elapses after final board S is unloaded from the first module M1, the establishment of the waste tape generation condition of first module M1 is released. When the establishment of the waste tape generation condition is released, first module M1 stops the conveyance of the waste tape and turns off the conveyance request signal to be output to the second module M2. When the predetermined time elapses after final board S is unloaded from the second module M2, the establishment of the waste tape generation condition of second module M2 is released. Since the conveyance request signal in off state is input from the first module M1, when the establishment of the waste tape generation condition of second module M2 is released, second module M2 t stops the conveyance of the waste tape, and turns off the vacuum request signal to be output to waste tape collection unit 50. When the vacuum request signal in off state is input from second module M2, waste tape collection unit 50 stops vacuuming the waste tape and turns off the vacuuming signal for the output to second module M2.

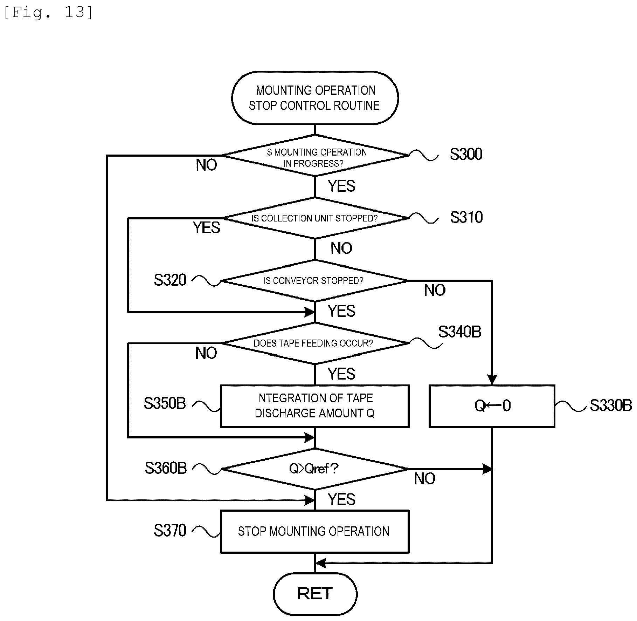

In the above-described embodiment, when waste tape collection unit 50 and the conveyor device 41 stop during the mounting operation, each component mounter 20 continues the mounting operation until the predetermined time elapses, and stops the mounting operation when the predetermined time elapses. However, the following may be adopted. Fig. 13 is a flowchart showing an example of a mounting operation stop control routine of a modified example which is executed by control device 48 of each component mounter 20. In the processes in Fig. 13, the same processes as those in Fig. 11 are denoted by the same step numbers, and a description thereof is omitted.

While the mounting operation stop control routine is executed, control device 48 resets the waste tape discharge amount Q to the value of 0 (step S330B) when it is determined that the mounting operation is in progress in step S300, and that the waste tape collection unit 50 is not stopped in steps S310 and S320 and waste tape conveyance device 40 (conveyor device 41) is not stopped. Further, during the mounting operation, when it is determined that waste tape collecting unit 50 is stopped, or that waste tape conveyance device 40 (conveyor device 41) is stopped, control device 48 determines whether a tape feeding by feeder 26 occurs (step S340B). As described above, when the tape feeding by feeder 26 occurs, tape cutting device 32 cuts the tape from which the component is picked up, so that the waste tape is generated. When it is determined that the tape feeding has occurred, control device 48 integrates tape discharge amount Q (step S350B).and when it is determined that the tape feeding has not occurred, step S350B is skipped. The integration of tape discharge amount Q is performed by integrating a predetermined amount each time the tape feeding occurs. The integrated amount may be increased or decreased in accordance with tape feeding amount or the type of tape. Control device 48 determines whether tape discharge amount Q is larger than threshold Qref (step S360B). Threshold Qref is an allowable amount to prevent the waste tape from overflowing from conveyor device 41 even when the waste tape is discharged to stopped conveyor device 41. When it is determined that the tape discharge amount Q is equal to or less than threshold Qref, control device 48 ends the routine while continuing the mounting operation, and when it is determined that tape discharge amount Q is greater than threshold Qref, the mounting operation is stopped (step S370), and the routine is ended.

In the above-described embodiment, the waste tape generation condition is established based on the fact that board S is loaded and the establishment is released when a state in which next board S is not loaded continues for a predetermined time after board S is unloaded. Any method may be adopted as long as it is possible to detect or estimate the occurrence of the waste tape, for example, such as assuming that the waste tape generation condition is established based on the operation of tape cutting device 32, and that the establishment is released when the state in which the operation of tape cutting device 32 is stopped continues for a predetermined time.

In the above-described embodiment, waste tape collection unit 50 collects the waste tape conveyed by waste tape conveyance device 40 to accommodation section 53 by vacuuming with vacuum pump 52. However, the waste tape collection unit may include a collection box installed at the conveyance end of the waste tape conveyance device 40, and the waste tape collected in the collection box may be collected by an operator. Further, the waste tape collection unit includes an automated guided vehicle equipped with a collection box to the conveyance end of waste tape conveyance device 40 and the waste tape collected in the collection box may be automatically collected by the automated guided vehicle. Alternatively, the waste tape collection unit may include a conveyor device installed at the conveyance end to waste tape conveyance device 40, and the waste tape may be automatically collected by the conveyor device. As described above, the waste tape collection unit may adopt any configuration as long as the waste tape conveyed by waste tape conveyance device 40 can be collected. In any aspect, the waste tape collection unit outputs a signal indicating whether the waste tape can be collected to the most downstream conveyor device in the waste tape conveyance direction.

In the above-described embodiment, although there is one collecting point of the waste tape, the present invention is not limited to this, and in a case where a line length of the component mounting line is long, collecting points of the waste tape may be multiple. For example, the waste tape conveyance direction of conveyor device 41 provided in component mounter 20 on the upstream side in the board conveyance direction from the vicinity of the center of the line length is configured to be a reverse direction (the upstream direction of the line) to the board conveyance direction, and the waste tape conveyance direction of conveyor device 41 provided in component mounter 20 on the downstream side in the board conveyance direction from the vicinity of the center of the line length is configured to be the same direction as the board conveyance direction (the downstream direction of the line). In this case, the collecting points of the waste tape are two points: the head collecting point at the beginning of the line and the collecting point at the end of the line.

### Industrial applicability

The present disclosure can be applied to a manufacturing industry of a waste tape conveyance device or a component mounting system.

### Reference Signs List

10 Component mounting system, 12 Printing machine, 20 Component mounter, 21 Housing, 22 Feeder base, 23 Board conveyance device, 24 Head, 25 Head moving mechanism, 26 Feeder, 27 Reel, 30 Waste tape discharge device, 31 Introduction duct, 32 Tape cutting device, 33 Discharge duct, 40 Waste tape conveyance device, 41 Conveyor device, 48 Control device, 50 Waste tape collection unit, 51 Vacuum section, 52 Vacuum pump, 53 Accommodation section, 53a Knob, 54 Display operation section, 58 Control device, S Board, T Tape, P Component.

## Claims

1. A waste tape conveyance device (40), which is applied to a component mounting system (10) with multiple component mounters (20) being arranged in series to configure a component mounting line, each of the multiple component mounters (20) having: a feeder (26) configured to feed a tape (T) accommodating multiple components (P) and supply the component (P); a board conveyance device (23) configured to convey a board (S) in a board conveyance direction; a mounting head (24) configured to pick up the component (P) from the tape (T) fed by the feeder (26) and mount the component (P) on the board (S) conveyed by the board conveyance device (23); and a cutting device (32) configured to cut the tape (T), being fed by the feeder (26) after the component (P) is picked up, to discharge the tape (T) as a waste tape, and wherein the waste tape conveyance device (40) is configured to convey the waste tape discharged from each component mounter (20) to a waste tape collection section (50) configured for receiving the waste tape from the most downstream conveyor device (41) in a waste tape conveyance direction, wherein the waste tape conveyance direction is parallel to the board conveyance direction, either in the same direction as the board conveyance direction or in the direction opposite to the board conveyance direction', the waste tape conveyance device (40) further comprising:
multiple conveyor devices (41) provided independently for at least each of the component mounters (20), and configured to deliver the waste tape from the conveyor device (41) to another conveyor device (41), being adjacently provided on a downstream side in the waste tape conveyance direction, or to the waste tape collection section (50),
**characterized in that**
when a predetermined waste tape generation condition, indicating that the waste tape is discharged to the conveyor device (41), is established for discharging the waste tape from the corresponding component mounter (20), or
when an operation request is input from another conveyor device (41) adjacent on an upstream side in the waste tape conveyance direction,
the conveyor device (41), being among the multiple conveyor devices (41) and adjacent to another conveyor device (41) on the downstream side in the waste tape conveyance direction, outputs the operation request to the other conveyor device (41) adjacent on the downstream side in the waste tape conveyance direction, and when an operation is confirmed in the other conveyor device (41) adjacent on the downstream side in the waste tape conveyance direction, the conveyor device (41) starts to operate,
while when the waste tape generation condition is not established during the operation and the operation request is not input from the other conveyor device (41) adjacent on the upstream side in the waste tape conveyance direction,
the conveyor device (41) stops operating and releases the operation request to the other conveyor device (41) adjacent on the downstream side in the waste tape conveyance direction, and
wherein when the waste tape generation condition is established, or when the operation request is input from the other conveyor device (41) adjacent on the upstream side in the waste tape conveyance direction with the waste tape collection section (50) being in a collectable state in which the waste tape is collectable,
a conveyor device (41), being among the multiple conveyor devices (41) and adjacent to the waste tape collection section (50) on the downstream side in the waste tape conveyance direction, starts to operate,
while when the waste tape generation condition is not established during the operation and the operation request is not input from the other conveyor device (41) adjacent on the upstream side in the waste tape conveyance direction,
the conveyor device (41) stops operating.

2. The waste tape conveyance device (40) according to claim 1,
wherein when the waste tape collection section (50) is in an uncollectable state in which the waste tape is uncollectable during the operation, the conveyor device (41) to which the waste tape collection section (50) is adjacent on the downstream side in the waste tape conveyance direction among the multiple conveyor devices (41) stops operating.

3. The waste tape conveyance device (40) according to claim 1 or 2,
wherein when the other conveyor device (41) adjacent on the downstream side in the waste tape conveyance direction stops operating during the operation, the conveyor device (41) to which the other conveyor device (41) is adjacent on the downstream side in the waste tape conveyance direction among multiple conveyor devices (41) stops operating.

4. The waste tape conveyance device (40) according to any one of claims 1 to 3,
wherein the waste tape generation condition is established based on the fact that the board (S) is loaded, and the establishment is released based on the fact that a state in which a new board (S) is not loaded continues for a predetermined time after the board (S) is unloaded.

5. A component mounting system (10) comprising:
a component mounting line in which multiple component mounters (20) having a feeder (26) configured to feed a tape (T) accommodating multiple components (P) and supply the component (P), a board conveyance device (23) configured to convey a board (S), a mounting head (24) configured to pick up the component (P) from the tape (T) fed by the feeder (26) and mount the component (P) on the board (S) conveyed by the board conveyance device (23), and a cutting device (32) configured to cut the tape (T), which is fed by the feeder (26), after the component (P) is picked up and discharge the tape (T) as a waste tape, are arranged in series; and
the waste tape conveyance device (40) according to any one of claims 1 to 4,
wherein when the waste tape collection section (50) is in an uncollectable state in which the waste tape is uncollectable during a component mounting operation or when an operation of any one of the multiple conveyor devices (41) is stopped, the component mounting line continues the component mounting operation until a predetermined time (Cref) elapses and when the predetermined time (Cref) has elapsed, the component mounting line stops the component mounting operation.

6. A component mounting system (10) comprising:
a component mounting line in which multiple component mounters (20) having a feeder (26) configured to feed a tape accommodating multiple components (P) and supply the component (P), a board conveyance device (23) configured to convey a board (S), a mounting head (24) configured to pick up the component (P) from the tape (T) fed by the feeder (26) and mount the component (P) on the board (S) conveyed by the board conveyance device (23), and a cutting device (32) configured to cut the tape (T), which is fed by the feeder (26), after the component (P) is picked up and discharge the tape (T) as a waste tape, are arranged in series; and
the waste tape conveyance device (40) according to any one of claims 1 to 5,
wherein when the waste tape collection section (50) is in an uncollectable state in which the waste tape is uncollectable during a component mounting operation or when an operation of any one of the multiple conveyor devices (41) is stopped, the component mounting line continues the component mounting operation until a discharge amount of the waste tape reaches a predetermined amount (Qref) in any of the multiple component mounters (20) and when the discharge amount (Q) of the waste tape has reached the predetermined amount (Qref), the component mounting line stops the component mounting operation.

## Patentansprüche

1. Abfallbandfördervorrichtung (40), die bei einem Komponentenmontagesystem (10) mit mehreren Komponentenmontagevorrichtungen (20) angewendet wird, die in Reihe angeordnet sind, um eine Komponentenmontagelinie zu konfigurieren, wobei jede der mehreren Komponentenmontagevorrichtungen (20) aufweist: eine Zuführeinrichtung (26), die konfiguriert ist, um ein Band (T) zuzuführen, das mehrere Komponenten (P) enthält, und um die Komponente (P) zuzuführen; eine Platinenfördervorrichtung (23), die zum Befördern einer Platine (S) in einer Platinenförderrichtung konfiguriert ist; einen Montagekopf (24), der dazu konfiguriert ist, die Komponente (P) von dem Band (T), das von der Zuführeinrichtung (26) zugeführt wird, aufzunehmen und die Komponente (P) auf der Platine (S), die von der Platinenfördervorrichtung (23) befördert wird, zu montieren; und eine Schneidevorrichtung (32), die konfiguriert ist, um das Band (T) zu schneiden, das von der Zuführeinrichtung (26) zugeführt wird, nachdem die Komponente (P) aufgenommen wurde, um das Band (T) als ein Abfallband abzugeben, und wobei die Abfallbandfördervorrichtung (40) so konfiguriert ist, dass sie das Abfallband, das von jeder Komponentenmontagevorrichtung (20) abgegeben wird, zu einem Abfallbandsammelabschnitt (50) befördert, der zum Empfangen des Abfallbands von der in einer Abfallbandförderrichtung am weitesten stromabwärts gelegenen Fördervorrichtung (41) konfiguriert ist, wobei die Abfallbandförderrichtung parallel zur Platinenförderrichtung ist, entweder in der gleichen Richtung wie die Platinenförderrichtung oder in der Richtung entgegengesetzt zur Platinenförderrichtung, wobei die Abfallbandfördervorrichtung (40) ferner umfasst:
mehrere Fördervorrichtungen (41), die unabhängig für mindestens jede der Komponentenmontagemaschinen (20) vorgesehen sind, und konfiguriert sind, um das Abfallband von der Fördervorrichtung (41) zu einer anderen Fördervorrichtung (41), die benachbart auf einer Seite stromabwärts in die Abfallbandförderrichtung vorgesehen ist, oder zum Abfallbandsammelabschnitt (50) zu transportieren,
**dadurch gekennzeichnet, dass**
wenn ein bestimmter Abfallband-Erzeugungszustand zum Abgeben des Abfallbands von der entsprechenden Komponentenmontagevorrichtung (20) eingetreten ist, der anzeigt, dass das Abfallband zu einer Fördervorrichtung (41) abgegeben wird, oder
wenn eine Betriebsanforderung von einer anderen Fördervorrichtung (41) eingegeben wird, die auf einer in der Abfallbandförderrichtung stromaufwärts gelegenen Seite benachbart ist,
die Fördervorrichtung (41), die eine der mehreren Fördervorrichtungen (41) ist und benachbart ist zu einer anderen Fördervorrichtung (41), die sich auf der in der Abfallbandförderrichtung stromabwärts gelegenen Seite befindet, die Betriebsanforderung an die andere, auf der in der Abfallbandförderrichtung stromabwärts gelegene Seite benachbarte Fördervorrichtung (41) ausgibt, und wenn ein Betrieb in der anderen, auf der in der Abfallbandförderrichtung stromabwärts gelegenen Seite benachbarten Fördervorrichtung (41) bestätigt wird, die Fördervorrichtung (41) zu arbeiten anfangt,
während, wenn der Abfallband-Erzeugungszustand während des Betriebs nicht eingetreten ist und die Betriebsanforderung von der anderen, auf der in der Abfallbandförderrichtung stromaufwärts gelegenen Seite benachbarten Fördervorrichtung (41) nicht eingegeben wird,
die Fördervorrichtung (41) den Betrieb einstellt und die Betriebsanforderung an die andere, auf der in der Abfallbandförderrichtung stromabwärts gelegenen Seite benachbarte Fördervorrichtung (41) beendet, und
wobei, wenn der Abfallband-Erzeugungszustand eingetreten ist, oder wenn die Betriebsanforderung von der anderen, auf der in der Abfallbandförderrichtung stromaufwärts gelegenen Seite benachbarten Fördervorrichtung (41) eingegeben wird, wobei sich der Abfallbandsammelabschnitt (50) in einem Sammelzustand befindet, in dem das Abfallband gesammelt werden kann,
eine Fördervorrichtung (41), die eine der mehreren Fördervorrichtungen (41) ist und sich neben dem Abfallbandsammelabschnitt (50) befindet, der auf der in der Abfallbandförderrichtung stromabwärts gelegenen Seite liegt, zu arbeiten anfangt,
während, wenn der Abfallband-Erzeugungszustand während des Betriebs nicht eingetreten ist und die Betriebsanforderung von der anderen, auf der in der Abfallbandförderrichtung stromaufwärts gelegenen Seite benachbarten Fördervorrichtung (41) nicht eingegeben wird,
die Fördereinrichtung (41) den Betrieb einstellt.

2. Abfallbandfördervorrichtung (40) nach Anspruch 1,
wobei, wenn sich der Abfallbandsammelabschnitt (50) in einem Sammelzustand befindet, in dem das Abfallband während des Betriebs nicht sammelbar ist, die Fördervorrichtung (41) unter den mehreren Fördervorrichtungen (41) zu der der Abfallbandsammelabschnitt (50) auf der in der Abfallbandförderrichtung stromabwärts gelegenen Seite benachbart ist, den Betrieb einstellt.

3. Abfallbandfördervorrichtung (40) nach Anspruch 1 oder 2,
wobei, wenn die andere, auf der in der Abfallbandförderrichtung stromabwärts gelegenen Seite benachbarte Fördervorrichtung (41) ihren Betrieb während des Betriebs einstellt, die Fördervorrichtung (41) unter mehreren Fördervorrichtungen (41), zu der die andere, Fördervorrichtung (41) auf der in den Abfallbandförderrichtung stromabwärts gelegenen Seite benachbart ist, den Betrieb einstellt.

4. Abfallbandfördervorrichtung (40) nach einem der Ansprüche 1 bis 3,
wobei der Abfallband-Erzeugungszustand eintritt, basierend auf der Tatsache, dass die Platine (S) geladen wird, und der Abfallband-Erzeugungszustand beendet wird, basierend auf der Tatsache, dass ein Zustand, in dem keine neue Platine (S) geladen wird, für eine bestimmte Zeit, nachdem die Platine (S) entladen wird, andauert.

5. Komponentenmontagesystem (10), umfassend:
eine Komponentenmontagelinie, in der mehrere Komponentenmontagevorrichtungen (20), die eine Zuführeinrichtung (26), die konfiguriert ist, um ein Band (T) zuzuführen, das mehrere Komponenten (P) enthält, und um die Komponente (P) zuzuführen, eine Platinenfördervorrichtung (23), die zum Befördern einer Platine (S) in einer Platinenförderrichtung konfiguriert ist, einen Montagekopf (24), der dazu konfiguriert ist, die Komponente (P) von dem Band (T), das von der Zuführeinrichtung (26) zugeführt wird, aufzunehmen und die Komponente (P) auf der Platine (S), die von der Platinenfördervorrichtung (23) befördert wird, zu montieren, und eine Schneidevorrichtung (32), die konfiguriert ist, um das Band (T) zu schneiden, das von der Zuführeinrichtung (26) zugeführt wird, nachdem die Komponente (P) aufgenommen wurde, und um das Band (T) als ein Abfallband abzugeben, aufweisen, in Reihe angeordnet sind; und
die Abfallbandfördervorrichtung (40) nach einem der Ansprüche 1 bis 4,
wobei, wenn sich der Abfallbandsammelabschnitt (50) in einem Sammelzustand befindet, in dem das Abfallband während eine Komponentenmontageoperation nicht sammelbar ist oder wenn der Betrieb von einer der mehreren Fördervorrichtungen (41) eingestellt wird, die Komponentenmontagelinie die Komponentenmontageoperation fortsetzt, bis eine bestimmte Zeit (Cref) verstrichen ist, und wenn die bestimmte Zeit (Cref) verstrichen ist, die Komponentenmontagelinie die Komponentenmontageoperation einstellt.

6. Komponentenmontagesystem (10), umfassend:
eine Komponentenmontagelinie, in der mehrere Komponentenmontagevorrichtungen (20), die eine Zuführeinrichtung (26), die konfiguriert ist, um ein Band (T) zuzuführen, das mehrere Komponenten (P) enthält, und um die Komponente (P) zuzuführen, eine Platinenfördervorrichtung (23), die zum Befördern einer Platine (S) in einer Platinenförderrichtung konfiguriert ist, einen Montagekopf (24), der dazu konfiguriert ist, die Komponente (P) von dem Band (T), das von der Zuführeinrichtung (26) zugeführt wird, aufzunehmen und die Komponente (P) auf der Platine (S), die von der Platinenfördervorrichtung (23) befördert wird, zu montieren, und eine Schneidevorrichtung (32), die konfiguriert ist, um das Band (T) zu schneiden, das von der Zuführeinrichtung (26) zugeführt wird, nachdem die Komponente (P) aufgenommen wurde, und um das Band (T) als ein Abfallband abzugeben, aufweisen, in Reihe angeordnet sind; und
die Abfallbandfördervorrichtung (40) nach einem der Ansprüche 1 bis 5,
wobei, wenn sich der Abfallbandsammelabschnitt (50) in einem Sammelzustand befindet, in dem das Abfallband während eine Komponentenmontageoperation nicht sammelbar ist oder wenn der Betrieb von einer der mehreren Fördervorrichtungen (41) eingestellt wird, die Komponentenmontagelinie die Komponentenmontageoperation fortsetzt, bis eine Abgabemenge des Abfallbands in einer der mehreren Komponentenmontagevorrichtungen (20) eine bestimmte Menge (Qref) erreicht, und wenn die Abgabemenge (Q) des Abfallbands die vorbestimmte Menge (Qref) erreicht hat, die Komponentenmontagelinie die Komponentenmontageoperation einstellt.

## Revendications

1. Dispositif de transport de bande perdue (40) qui est appliqué à un système de montage de composants (10) comportant de multiples dispositifs de montage de composants (20) disposés en série pour configurer une ligne de montage de composants, chacun des multiples dispositifs de montage de composants (20) comportant un dispositif d'alimentation (26) configuré pour délivrer une bande (T) accueillant de multiples composants (P) et pour délivrer le composant (P) ; un dispositif de transport de carte (23) configuré pour transporter une carte (S) dans une direction de transport de carte ; une tête de montage (24) configurée pour prélever le composant (P) de la bande (T) délivrée par le dispositif d'alimentation (26) et pour monter le composant (P) sur la carte (S) transportée par le dispositif de transport de carte (23) ; ainsi qu'un dispositif de découpe (32) configuré pour couper la bande (T) délivrée par le dispositif d'alimentation (26) après le prélèvement du composant (P), afin d'éjecter la bande (T) sous forme d'une bande perdue, et où le dispositif de transport de bande perdue (40) est configuré pour transporter la bande perdue éjectée de chaque dispositif de montage de composants (20) vers une section de recueil des bandes perdues (50) configurée pour recevoir la bande perdue provenant du dispositif de transport (41) situé le plus en aval dans la direction de transport de la bande perdue, la direction de transport de la bande perdue étant parallèle à la direction de transport de cartes, soit dans le même sens que la direction de transport de cartes soit dans le sens opposé à la direction de transport de cartes ; le dispositif de transport de bande perdue (40) comprenant en outre :
de multiples dispositifs de transport (41) disposés indépendamment pour au moins chacun des dispositifs de montage de composants (20) et configurés pour délivrer la bande perdue depuis le dispositif de transport (41) jusqu'à un autre dispositif de transport (41) disposé de façon adjacente à l'aval dans la direction de transport de la bande perdue, ou bien vers la section de recueil des bandes perdues (50),
**caractérisé en ce que :**
lorsqu'une condition prédéterminée de génération de bande perdue, indiquant que la bande perdue est éjectée vers le dispositif de transport (41), est établie pour éjecter la bande perdue du dispositif correspondant de montage de composants (20), ou
lorsqu'une demande de manoeuvre est appliquée en entrée par un autre dispositif de transport (41) adjacent du côté amont dans la direction de transport de la bande perdue,
le dispositif de transport (41), parmi les multiples dispositifs de transport (41) et adjacent à un autre dispositif de transport (41) situé à l'aval dans la direction de transport de bande perdue, délivre en sortie la demande de manoeuvre à l'autre dispositif de transport (41) adjacent du côté aval dans la direction de transport de bande perdue, et lorsqu'une manoeuvre est confirmée dans l'autre dispositif de transport (41) adjacent du côté aval dans la direction de transport de la bande perdue, le dispositif de transport (41) commence à fonctionner,
alors que lorsque la condition de génération de bande perdue n'est pas établie pendant le fonctionnement et que la demande de manoeuvre n'est pas appliquée en entrée depuis l'autre dispositif de transport (41) adjacent du côté amont dans la direction de transport de bande perdue,
le dispositif de transport (41) arrête de fonctionner et relâche la demande de manoeuvre sur l'autre dispositif de transport (41) adjacent du côté aval dans la direction de transport de la bande perdue, et
dans lequel, lorsque la condition de génération de bande perdue est établie ou lorsque la demande de manoeuvre est appliquée en entrée depuis l'autre dispositif de transport (41) adjacent du côté amont dans la direction de transport de bande perdue, alors que la section de recueil de bandes perdues (50) se trouve à l'état de pouvoir collecter dans lequel la bande perdue peut être recueillie,
un dispositif de transport (41) se trouvant parmi les multiples dispositifs de transport (41) et adjacent à la section de recueil des bandes perdues (50) du côté aval dans la direction de transport de bande perdue, commence à fonctionner,
alors que lorsque la condition de génération de bande perdue n'est pas établie pendant le fonctionnement et que la demande de manoeuvre n'est pas appliquée en entrée depuis l'autre dispositif de transport (41) adjacent du côté amont dans la direction de transport de bande perdue,
le dispositif de transport (41) cesse de fonctionner.

2. Dispositif de transport de bande perdue (40) selon la revendication 1,
dans lequel, lorsque la section de recueil de bandes perdues (50) se trouve dans un état où elle ne peut pas collecter dans lequel la bande perdue ne peut pas être recueillie pendant la manoeuvre, le dispositif de transport (41), auquel est adjacente la section de recueil de bandes perdues (50) du côté aval dans la direction de transport de bande perdue parmi les multiples dispositifs de transport (41), cesse de fonctionner.

3. Dispositif de transport de bande perdue (40) selon la revendication 1 ou la revendication 2,
dans lequel, lorsque l'autre dispositif de transport (41) adjacent du côté aval dans la direction de transport de bande perdue cesse de fonctionner pendant la manoeuvre, le dispositif de transport (41), auquel est adjacent l'autre dispositif de transport (41) du côté aval dans la direction de transport de bande perdue parmi les multiples dispositifs de transport (41), cesse de fonctionner.

4. Dispositif de transport de bande perdue (40) selon l'une quelconque des revendications 1 à 3,
dans lequel la condition de génération de bande perdue est établie sur la base du fait que la carte (S) est chargée, et l'action est relâchée sur la base du fait que se poursuit pendant une durée prédéterminée après le déchargement de la carte (S) l'état dans lequel aucune nouvelle carte (S) n'est chargée.

5. Système de montage de composants (10) comprenant :
une ligne de montage de composants dans laquelle sont disposés en série de multiples dispositifs de montage de composants (20) comportant un dispositif d'alimentation (26) configuré pour délivrer une bande (T) accueillant de multiples composants (P) et pour délivrer le composant (P), un dispositif de transport de carte (23) configuré pour transporter une carte (S) dans une direction de transport de carte, une tête de montage (24) configurée pour prélever le composant (P) de la bande (T) délivrée par le dispositif d'alimentation (26) et pour monter le composant (P) sur la carte (S) transportée par le dispositif de transport de carte (23), ainsi qu'un dispositif de découpe (32) configuré pour couper la bande (T) délivrée par le dispositif d'alimentation (26) après le prélèvement du composant (P), afin d'éjecter la bande (T) sous forme d'une bande perdue, et
le dispositif de transport de bande perdue conforme à l'une quelconque des revendications 1 à 4,
dans lequel, lorsque la section de recueil de bande perdue (50) est dans un état où elle ne peut pas collecter dans lequel la bande perdue ne peut pas être recueillie pendant une opération de montage de composants ou lorsque que le fonctionnement de l'un quelconque des multiples dispositifs de transport est stoppé, la ligne de montage de composants poursuit l'opération de montage de composants jusqu'à ce qu'une durée prédéterminée (Cref) se soit écoulée, et, lorsque la durée prédéterminée (Cref) s'est écoulée, la ligne de montage de composants arrête l'opération de montage de composants.

6. Système de montage de composants (10) comprenant :
une ligne de montage de composants dans laquelle sont disposés en série de multiples dispositifs de montage de composants (20) comportant un dispositif d'alimentation (26) configuré pour délivrer une bande (T) accueillant de multiples composants (P) et pour délivrer le composant (P), un dispositif de transport de carte (23) configuré pour transporter une carte (S) dans une direction de transport de carte, une tête de montage (24) configurée pour prélever le composant (P) de la bande (T) délivrée par le dispositif d'alimentation (26) et pour monter le composant (P) sur la carte (S) transportée par le dispositif de transport de carte (23), ainsi qu'un dispositif de découpe (32) configuré pour couper la bande (T) délivrée par le dispositif d'alimentation (26) après le prélèvement du composant (P), afin d'éjecter la bande (T) sous forme d'une bande perdue, et
le dispositif de transport de bande perdue conforme à l'une quelconque des revendications 1 à 5,
dans lequel, lorsque la section de recueil de bande perdue (50) est dans un état où elle ne peut pas collecter dans lequel la bande perdue ne peut pas être recueillie pendant une opération de montage de composants ou lorsque que le fonctionnement de l'un quelconque des multiples dispositifs de transport est stoppé, la ligne de montage de composants poursuit l'opération de montage de composants jusqu'à ce qu'une valeur d'éjection de la bande perdue atteigne une quantité prédéterminée (Qref) dans l'un quelconque des multiples dispositifs de montage de composants (20) et lorsque la valeur d'éjection (Q) de la bande perdue a atteint la quantité prédéterminée (Qref), la ligne de montage de composants arrête l'opération de montage de composants.
